# EUROPÄISCHE PATENTANMELDUNG

(11) **EP 1 235 110 A2**
(43) Veröffentlichungstag der Anmeldung: **28.08.2002**
(21) Anmeldenummer: 02000932.0
(22) Anmeldetag: 16.01.2002
(51) Int. Cl.: G03F 7/20, G02B 7/02

(54) **Optisches Strahlführungssystem und Verfahren zur Kontaminationsverhinderung optischer Komponenten hiervon**

(30) Priorität: 24.02.2001 DE 10109031
(71) Anmelder: CARL ZEISS SEMICONDUCTOR MANUFACTURING TECHNOLOGIES AG, 73447 Oberkochen (DE)
(72) Erfinder: Freitag, Ansgar, 89522 Heidenheim (DE); Bingel, Ulrich, 73457 Lauterburg (DE); Distl, Josef, 73447 Oberkochen (DE); Hamm, Uwe W., 89129 Langenau (DE)
(74) Vertreter: Patentanwälte Ruff, Wilhelm, Beier, Dauster & Partner

(57) **Zusammenfassung**

2.1. Die Erfindung bezieht sich auf ein Verfahren zur Verminderung der Kontamination wenigstens einer optischen Komponente, die in einen Strahlführungsraum eingebracht ist und von einer den Strahlführungsraum definierenden Einfassung gehalten wird, sowie auf ein diesbezügliches optisches Strahlführungssystem.
2.2. Erfindungsgemäß werden die an den Strahlführungsraum (6) angrenzenden Oberflächen der Einfassung (4, 5) wenigstens teilweise mit einer vorzugsweise nicht reflexionserhöhenden Ausgasungssperrschicht (7) beschichtet.
2.3. Verwendung z.B. in mit UV-Licht arbeitenden Lithographie-Belichtungsanlagen.

## Beschreibung

Die Erfindung bezieht sich auf ein Verfahren zur Verminderung der Kontamination wenigstens einer optischen Komponente nach dem Oberbegriff des Anspruchs 1 und auf ein diesbezügliches optisches Strahlführungssystem für UV-Licht mit einer Einfassung, die einen Strahlführungsraum definiert und die wenigstens eine optische Komponente hält, die in den Strahlführungsraum eingebracht ist.

Derartige optische Strahlführungssysteme werden beispielsweise in UV-Lasern und in Lithographie-Belichtungsanlagen zur strukturerzeugenden UV-Belichtung von Halbleiterwafern verwendet. Die Einfassung definiert den Strahlführungsraum, der für den UV-Lichtstrahlengang zur Verfügung steht, und hält die eine oder mehreren darin eingebrachten optischen Komponenten. Mit anderen Worten bezeichnet der Begriff Einfassung vorliegend diejenigen gehäuse- und/oder fassungsartigen Bauteile, die an den Strahlführungsraum angrenzende Oberflächen besitzen und letzteren begrenzen und/oder die eine oder mehreren optischen Komponenten halten.

Bei mit UV-Licht arbeitenden Lithographie-Belichtungsanlagen ist es bekannt, dass an der Oberfläche der optischen Komponenten Kontamination, d.h. Beschlag, auftreten und deren zu erfüllende optische Funktion merklich beeinträchtigen kann, z.B. die Abbildungsqualität von Linsen in Projektionsobjektiven von Lithographie-Belichtungsanlagen zwischen der Position einer strukturgebenden Maske und der Position eines zu belichtenden Wafers oder im vorgeschalteten Maskenbeleuchtungsteil dieser Anlagen.

Traditionell wird das Auftreten solcher Kontaminationseffekten meist Verunreinigungen zugeschrieben, die direkt vom belichteten Substrat oder der verwendeten Gasatmosphäre stammen oder sich nach der Fertigung des Strahlführungssystems an den dem Strahlführungsraum zugewandten Oberflächen der Einfassung und/oder der optischen Komponenten aus Substanzen bilden, die in der Gasatmosphäre enthalten sind. Solche Anlagerungen können bekanntermaßen durch verschiedene Dekontaminierungsverfahren im laufenden Betrieb entfernt werden, siehe die Offenlegungsschrift DE 198 30 438 A1, dies erfordert jedoch entsprechenden Zusatzaufwand und eventuell Unterbrechungen des Belichtungsbetriebs.

In der Patentschrift US 5.602.683 wird zur Kontaminationsverhinderung bei einem Linsensystem mit mehreren Linsenelementen, die in einer den Strahlführungsraum umgebenden Linsenhalterung angeordnet sind, vorgeschlagen, den Strahlführungsraum innerhalb der Linsenhalterung mit einem ozonhaltigen Gas gefüllt zu halten.

In der Patentschrift US 5.696.623 werden Oxide von C, S, Sn, Mg, Si und dergleichen für die Kontamination des Linsensystems einer UV-Belichtungsanlage verantwortlich gemacht, wobei angenommen wird, dass sich diese Oxide aus Bestandteilen eines Atmosphärengases oder Bestandteilen von Ausgasungen aus dem Linsenaufbau bilden. Zur Kontaminationsverhinderung wird vorgeschlagen, in den Raum um die Linsenoberflächen ein nicht oxidierendes Gas einzubringen, z.B. ein Edelgas, ein reduzierendes Gas oder ein von Sauerstoff weitgehend befreites Atmosphärengas.

In der Patentschrift US 5.685.895 wird von Untersuchungen berichtet, aus denen geschlossen wurde, dass sich die Quellen für Kontaminationen optischer Elemente in Lithographie-Belichtungsanlagen meistens in der Umgebung der Anlage und weniger in der Anlage selbst befinden, und zwar insbesondere Ammoniumradikale, Schwefel- und Salpetersäureradikale sowie organische Silane. Als eine Ursache für häufig zu beobachtende Ammoniumsulfat-Kontaminationen wird die Verwendung von schwarzanodisiertem Aluminium als Halterung oder Abschirmung angegeben. Das schwarz anodisierte Aluminium enthält einen Diazo-Farbstoff und wird einer Behandlung mit Schwefelsäure unterzogen. Diese Substanzen können erzeugende Quellen von Ammoniumradikalen und Schwefelsäureradikalen sein, die sich durch eine photochemische Reaktion zu Ammoniumsulfat verbinden.

Die Patentschrift US 6.014.263 befasst sich mit der Verhinderung von Kontamination einer optischen Linse in einer oxidierenden Umgebung, insbesondere bei hohen Temperaturen, z.B. einer Linse in einem Pyrometer zur Erfassung der Abgastemperatur einer Gasturbine. Der Linsenbeschlag wird dort der Bildung eines flüchtigen Oxids an der Oberfläche einer zugehörigen Linseneinfassung zugeschrieben. Dabei wurde gefunden, dass sich bei den dortigen hohen Betriebstemperaturen von etwa 650°C und mehr flüchtige Oxide von Chrom und/oder Molybdän bilden können, das in einem chrom- und/oder molybdänhaltigen Einfassungsmaterial enthalten ist, wie z.B. in Edelstahl. Diese flüchtigen Oxide können dann auf die Linsenoberfläche gelangen und dort den Beschlag verursachen. Als Abhilfe wird das Aufbringen einer Schutzschicht auf den dem Oxidationseinfluss unterliegenden Oberflächenbereich der Einfassung bzw. Halterung der Linse vorgeschlagen, mit der verhindert werden soll, dass im Linsenhalterungsmaterial enthaltenes Chrom oder Molybdän an der Oberfläche mit der oxidierenden Atmosphäre in Kontakt kommt. Die Beschichtung erfolgt derart, dass sie unter den herrschenden hohen Temperaturen einen schützenden Belag aus nichtflüchtigem Aluminiumoxid bildet.

Der Erfindung liegt als technisches Problem die Bereitstellung eines Verfahrens der eingangs genannten Art zugrunde, mit dem sich Kontaminationserscheinungen bei optischen Komponenten eines mit UV-Licht arbeitenden Strahlführungssystems in neuartiger und vorteilhafter Weise vermeiden oder jedenfalls reduzieren lassen, ohne dass dadurch der Betrieb und/oder die Strahlführungsqualität des Strahlführungssystems ungünstig beeinflusst werden. Des weiteren soll ein entsprechendes Strahlführungssystem bereitgestellt werden.

Die Erfindung löst dieses Problem durch die Bereitstellung eines Verfahrens mit den Merkmalen des Anspruchs 1 und eines optischen Strahlführungssystems mit den Merkmalen des Anspruchs 6. Als erfindungsgemäße Maßnahme zur Kontaminationsverminderung werden die an den Strahlführungsraum angrenzenden Oberflächen der Einfassung wenigstens teilweise mit einer Ausgasungssperrschicht beschichtet. Es zeigt sich, dass durch diese Maßnahme allein oder in Verbindung mit anderweitigen, herkömmlichen Maßnahmen die Kontamination von Linsen und anderen optischen Komponenten in optischen Strahlführungssystemen für UV-Licht deutlich verringert werden kann.

Die Erfinder haben diesbezüglich festgestellt, dass häufig ein wesentlicher Beitrag zur Kontamination optischer Komponenten in solchen Systemen von Ausgasungen aus dem Material der Einfassung stammt, häufig einem Edelstahlmaterial, wie X14CrMoS17. Die Ausgasungssperrschicht ist per definitionem so gewählt, dass sie derartige Ausgasungen aus dem Einfassungsmaterial ganz oder wenigstens teilweise blockiert, d.h. für die ausgasenden Substanzen sperrend wirkt. Die Oberflächenbeschichtung mit der Ausgasungssperrschicht kann insbesondere für Fassungen von Linsen und anderen optischen Komponenten des Systems vorgesehen sein, gegebenenfalls aber auch für andere, den Strahlführungsraum einfassende Gehäuseteile.

Bevorzugt ist gemäß Anspruch 2 bzw. 7 die Ausgasungssperrschicht so gewählt, dass sie für das verwendete UV-Licht nicht reflexionserhöhend wirkt, d.h. der Reflexionsgrad der mit ihr beschichteten Oberflächenabschnitte der Einfassung ist für das UV-Licht im verwendeten Wellenlängenbereich nicht höher als ohne die Beschichtung. Dies gewährleistet, dass die Strahlführungsqualität des Systems nicht durch erhöhte Reflexionen des verwendeten UV-Lichts an der Ausgasungssperrschicht beeinträchtigt wird.

In einer Weiterbildung der Erfindung nach Anspruch 3 bzw. 8 ist die Ausgasungssperrschicht in ihrem Reflexionsverhalten so gewählt, dass sie mindestens bei den drei UV-Wellenlängen von 193nm, 248nm und 365nm nicht reflexionserhöhend wirkt, die häufig in Lithographie-Belichtungsanlagen verwendet werden.

Spezielle Ausgasungssperrschichten, die gut haftend aufgebracht werden können und eine hohe Ausgasungssperrwirkung für typischerweise beobachtete Ausgasungsbestandteile, insbesondere auch SOₓ, zeigen und dabei reflexionsmindernd für das verwendete UV-Licht wirken, sind im Anspruch 4 bzw. 9 angegeben. Dabei erweist sich insbesondere die chemisch abgeschiedene Nickelschicht als stark ausgasungssperrend speziell auch bezüglich eventuellen SOₓ-Ausgasungen, wobei diese Nickelschicht in Ausgestaltung der Erfindung nach Anspruch 5 bzw. 10 eine unter Verwendung von Natriumhypophosphit als Reduktionsmittel chemisch abgeschiedene NiP-Legierungsschicht mit einem Phosphor-Minoritätsanteil sein kann.

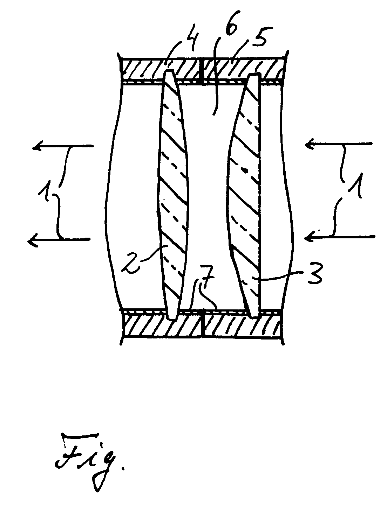

Vorteilhafte Ausführungsformen der Erfindung werden nachfolgend unter Bezugnahme auf die Zeichnung näher erläutert.

Die einzige Figur zeigt einen schematischen, ausschnittweisen Längsschnitt durch einen Teil eines optischen Strahlführungssystems für UV-Licht.

In der Figur ist ein Teil eines optischen Strahlführungssystems in einer ausschnittweisen Längsschnittansicht dargestellt, wobei das System zur optischen Strahlführung eines UV-Lichtstrahls 1 ausgelegt ist. Bei diesem UV-Strahlführungssystem kann es sich insbesondere um ein Projektionsobjektivsystem einer Lithographie-Belichtungsanlage handeln, das zwischen einem Maskenhalter und einem Waferhalter angeordnet ist, oder um eine Beleuchtungseinrichtung, die zwischen einer UV-Laserlichtquelle und dem Maskenhalter angeordnet ist, oder auch um diesen, der Beleuchtungseinrichtung vorgeschalteten Laserquellen-Systemteil.

Das optische Strahlführungssystem beinhaltet im Strahlengang des UV-Lichts 1 in herkömmlicher Weise mehrere optische Komponenten, von denen stellvertretend zwei Linsen 2, 3 gezeigt sind. Die optischen Komponenten 2, 3 sind jeweils in einer ringförmigen Fassung 4, 5 gehalten. Die Fassungen 4, 5 bestehen typischerweise aus einem Stahlmaterial, wie dem Edelstahl X14CrMoS17, und sind stirnseitig miteinander verbunden. Sie fungieren im entsprechenden Abschnitt des Strahlführungssystems als Einfassung, die einen innenliegenden Strahlführungsraum 6 begrenzt, in den die beiden Linsen 2, 3 an gewünschten Positionen des UV-Lichtstrahlengangs 1 eingebracht sind.

Untersuchungen haben gezeigt, dass im Betrieb des Systems Beschlag bzw. Kontamination an den Oberflächen der Linsen 2, 3 selbst dann auftreten kann, wenn die Edelstahl-Fassungen 4, 5 einer reinigenden und passivierenden Behandlung unterzogen wurden. Die Erfinder haben erkannt, dass solche Kontaminationseffekte in manchen Fällen nicht, wie herkömmlicherweise meist angenommen, durch von außen in den Strahlführungsraum 6 gelangende Substanzen verursacht werden, die z.B. aus der im Strahlführungsraum 6 verwendeten Gasatmosphäre oder vom belichteten Substrat stammen, sondern von Ausgasungen aus den Fassungen 4, 5 herrühren. Als gegenwirkende, kontaminationsmindernde Maßnahme sind daher die Fassungen 4, 5 auf ihrer dem Strahlführungsraum 6 zugewandten Oberfläche mit einer Ausgasungssperrschicht 7 versehen.

Art und Zusammensetzung der Ausgasungssperrschicht 7 sind daran angepasst, welche Substanzen primär aus dem jeweils verwendeten Material der Fassungen 4, 5 ausgasen, um dieses Ausgasen ganz zu unterbinden oder jedenfalls merklich zu reduzieren. Dabei zeigt sich, dass zum Blockieren der bei Stahlfassungen hauptsächlich beobachteten Ausgasungen, unter anderem insbesondere auch SOₓ-Ausgasungen, vor allem chemisch abgeschiedene Nickelschichten, Silber-, Gold- und Tantalschichten als Ausgasungssperrschichten geeignet sind. Diese Schichten erfüllen gleichzeitig die weitere Forderung an die Ausgasungssperrschicht 7, dass sie nicht zu erhöhten Streulichtreflexionen für das verwendete UV-Licht führt. Speziell weisen die genannten Ausgasungssperrschichten im für Lithographie-Belichtungsanlagen wichtigen UV-Wellenlängenbereich zwischen 193nm und 365nm und speziell für die Wellenlängen 193nm, 248nm und 365nm zum Teil signifikante Reflexionsminderungseigenschaften auf, im Gegensatz beispielsweise zu Schichten aus TiN oder CrN, die bei diesen Wellenlängen sowohl bei einem Einfallswinkel von 0° als auch von 30° meist zu erhöhten Reflexionen führen.

Als besonders ausgasungshemmend haben die Erfinder das Beschichten der Edelstahl-Fassungen 4, 5 mit einer chemisch abgeschiedenen Nickelschicht als Ausgasungssperrschicht erkannt, und zwar speziell in Form einer NiP-Legierungsschicht, die chemisch in einem Elektrolyt abgeschieden wird, der Nickel in Form von Nickelsulfat und als Reduktionsmittel Natriumhypophosphit enthält. Die bei dieser elektrochemischen Reaktion zusätzlich entstehenden Phosphoratome werden mit in die Schicht eingebaut, wobei die entstehende NiP-Legierungsschicht einen typischen Phosphor-Masseanteil zwischen 3% und 15% aufweist. Diese chemisch abgeschiedene Ni- bzw. genauer NiP-Schicht reduziert insbesondere die störenden SOₓ-Ausgasungen um rund zwei Größenordnungen.

Alle genannten Ausgasungssperrschichten lassen sich mit ausreichender Haftung und hoher Gleichförmigkeit stromlos chemisch oder durch andere Abscheideverfahren, wie PVD-Verfahren, auf herkömmliche Fassungsmaterialien, wie Edelstahl, aufbringen. Je besser die Schichthaftung ist, um so stärker werden tendenziell die Ausgasungen reduziert. Die genannten Ausgasungssperrschichten sind problemlos nachbearbeitbar, z.B. im Reparaturfall. Typische Schichtdicken für die Ausgasungssperrschicht 7 liegen zwischen 5µm bis 20µm. Mit dieser Dicke wird eine ausreichende Ausgasungssperrfunktion erzielt, während andererseits Schichtdicken in diesem Bereich noch so dünn sind, dass sie mechanisch, z.B. in Schraubgewinden, nicht stören.

Die obige Beschreibung eines vorteilhaften Ausführungsbeispiels zeigt, dass sich erfindungsgemäß Kontaminationen von Linsen und anderen optischen Komponenten eines Strahlführungssystems für UV-Licht, die von Ausgasungen aus dem Material einer den Strahlführungsraum definierenden Einfassung verursacht werden, wirksam vermindern lassen, indem die Einfassung, insbesondere die Fassungen der optischen Komponenten oder andere strahlführungsraumdefinierende Gehäuseteile, auf ihrer dem Strahlführungsraum zugewandten Oberfläche ganz oder wenigstens teilweise mit der vorzugsweise nicht reflexionserhöhenden Ausgasungssperrschicht beschichtet werden. Es versteht sich, dass diese Maßnahme für beliebige, mit UV-Licht arbeitende optische Strahlführungssysteme geeignet ist, speziell auch wie gesagt für Projektionsobjektive, Beleuchtungseinrichtungen und Laserlichtquellen von mit UV-Licht arbeitenden Lithographie-Belichtungsanlagen. Dabei zeigt sich, dass die hinsichtlich Ausgasungssperrwirkung und Reflexionsminderung geeignet ausgewählte Ausgasungssperrschicht nicht nur zum Blockieren von Ausgasungen aus Stahlmaterial geeignet ist, sondern auch aus Aluminiumlegierungen, wie sie für einfassende, strahlführungsraumdefinierende Bauteile häufig z.B. in UV-Lasern verwendet werden.

## Patentansprüche

1. Verfahren zur Verminderung von Kontamination wenigstens einer optischen Komponente (2, 3), die in einen Strahlführungsraum (6) eingebracht ist und von einer den Strahlführungsraum definierenden Einfassung (4, 5) gehalten wird,
**dadurch gekennzeichnet, dass**
die an den Strahlführungsraum (6) angrenzenden Oberflächen der Einfassung (4, 5) wenigstens teilweise mit einer Ausgasungssperrschicht (7) beschichtet werden.

2. Verfahren nach Anspruch 1, weiter **dadurch gekennzeichnet, dass** die Ausgasungssperrschicht nicht reflexionserhöhend gewählt ist.

3. Verfahren nach Anspruch 1 oder 2, weiter **dadurch gekennzeichnet, dass** die Ausgasungssperrschicht (7) so gebildet wird, dass sie für UV-Licht mit Wellenlängen von 193nm, 248nm und 365nm nicht reflexionserhöhend wirkt.

4. Verfahren nach einem der Ansprüche 1 bis 3, weiter **dadurch gekennzeichnet, dass** als Ausgasungssperrschicht (7) eine chemisch abgeschiedene Nickelschicht, eine Silber-, Gold- oder Tantalschicht aufgebracht wird.

5. Verfahren nach Anspruch 4, weiter **dadurch gekennzeichnet, dass** als Ausgasungssperrschicht eine chemisch abgeschiedene Nickelschicht in Form einer NiP-Legierungsschicht durch einen chemischen Abscheideprozess in einem Elektrolyt aufgebracht wird, der Natriumhypophosphit als Reduktionsmittel enthält.

6. Optisches Strahlführungssystem für UV-Licht, insbesondere einer Lithographie-Belichtungsanlage, mit
- einer Einfassung (4, 5), die einen Strahlführungsraum (6) definiert und wenigstens eine optische Komponente (2, 3) hält, die in den Strahlführungsraum eingebracht ist,
**dadurch gekennzeichnet, dass**
- die an den Strahlführungsraum (6) angrenzenden Oberflächen der Einfassung (4, 5) wenigstens teilweise mit einer nicht reflexionserhöhenden Ausgasungssperrschicht (7) beschichtet sind.

7. Optisches Strahlführungssystem nach Anspruch 6, weiter **dadurch gekennzeichnet, dass** die Ausgasungssperrschicht (7) nicht reflexionserhöhend ist.

8. Optisches Strahlführungssystem nach Anspruch 6 oder 7, weiter **dadurch gekennzeichnet, dass** die Ausgasungssperrschicht (7) für UV-Licht mit Wellenlängen von 193nm, 248nm und 365nm nicht reflexionserhöhend wirkt.

9. Optisches Strahlführungssystem nach einem der Ansprüche 6 bis 8, weiter **dadurch gekennzeichnet, dass** die Ausgasungssperrschicht (7) eine chemisch abgeschiedene Nickelschicht, eine Silber-, Gold- oder Tantalschicht ist.

10. Optisches Strahlführungssystem nach Anspruch 9, weiter **dadurch gekennzeichnet, dass** die chemisch abgeschiedene Nickelschicht eine chemisch in einem Elektrolyt mit dem Reduktionsmittel Natriumhypophosphit als Reduktionsmittel abgeschiedene NiP-Legierungsschicht ist.
